# EUROPEAN PATENT APPLICATION

(11) **EP 1 739 056 A2**
(43) Date of publication of application: **03.01.2007**
(21) Application number: 06116162.6
(22) Date of filing: 27.06.2006
(51) Int. Cl.: B81C 5/00

(54) **Systems and methods for direct silicon epitaxy thickness measuring**

(30) Priority: 29.06.2005 US 695369 P; 08.11.2005 US 269302
(71) Applicant: Honeywell International, Inc., Morristown, New Jersey 07962 (US)
(72) Inventor: Yu, Lianzhong, Redmond, WA 98053 (US); Yang, Ken L., Bellevue, WA 98006 (US)
(74) Representative: Haley, Stephen

(57) **Abstract**

Systems and methods for measuring thickness of an epitaxial layer (26) grown on a silicon wafer (20) An oxide layer (22) is generated on a side of the silicon wafer (20). One or more posts of oxide (24) are created from the oxide layer (22) by masking and removing unwanted oxide. An epitaxial layer (26) is grown on the side of the silicon wafer (20) over the one or more oxide posts (24). The epitaxial layer (26) is removed in an area that includes at least the epitaxial layer (26) grown on the one or more oxide posts (24). Then, the one or more oxide posts are removed (24). The thickness of the epitaxial layer (26) is determined by measuring a distance along an axis between a surface (32) of the silicon wafer (20) where one of the one or more oxide posts (24) previously attached and a top surface (30) of the epitaxial layer (26), the axis being perpendicular to the surface (32) of the wafer (20).

## Description

In Micro-Electro Mechanical Systems (MEMS) device fabrication, silicon epitaxy layer thickness must meet very tight tolerances in order to attain desired performance criteria. Presently, analysis of epitaxy layer thickness is performed in a destructive manner. A wafer is cut and stained then analyzed under a microscope in order to determine the thickness of the epitaxy layer. Thus, a wafer is destroyed and sometimes multiple waters are destroyed in a batch of wafers in order to accurately analyze the results of the epitaxy layer manufacturing process.

Therefore, there exists a need for analyzing the epitaxy layer thickness without destroying product.

The present invention provides systems and methods for measuring thickness of an epitaxial layer grown on a silicon wafer. In one embodiment an oxide layer is generated on a side of the silicon wafer. One or more posts of oxide are created from the oxide layer by masking and removing unwanted oxide. An epitaxial layer is grown on the side of the silicon wafer over the one or more oxide posts. The epitaxial layer is removed in an area that includes at least the epitaxial layer grown on the one or more oxide posts. Then, the one or more oxide posts are removed. The thickness of the epitaxial layer is determined by measuring a difference between distance in height of a surface of the silicon wafer previously attached to one of the one or more oxide posts and a top surface of the epitaxial layer.

The preferred and alternative embodiments of the present invention are described in detail below with reference to the following drawings.
FIGURES 1A-1G illustrate partial cross-sectional images of stages in a process for manufacturing a wafer in order to analyze epitaxy thickness;
FIGURE 2 illustrates a top-down view of a wafer having epitaxy thickness test regions formed in accordance with an embodiment of the present invention;
FIGURE 3 is a blocked diagram of a system used to measure epitaxy thickness after the process shown in FIGURES 1A-1G is performed; and
FIGURE 4 illustrates an example process for acting upon the results of the measurements performed by the measuring system shown in FIGURE 3.

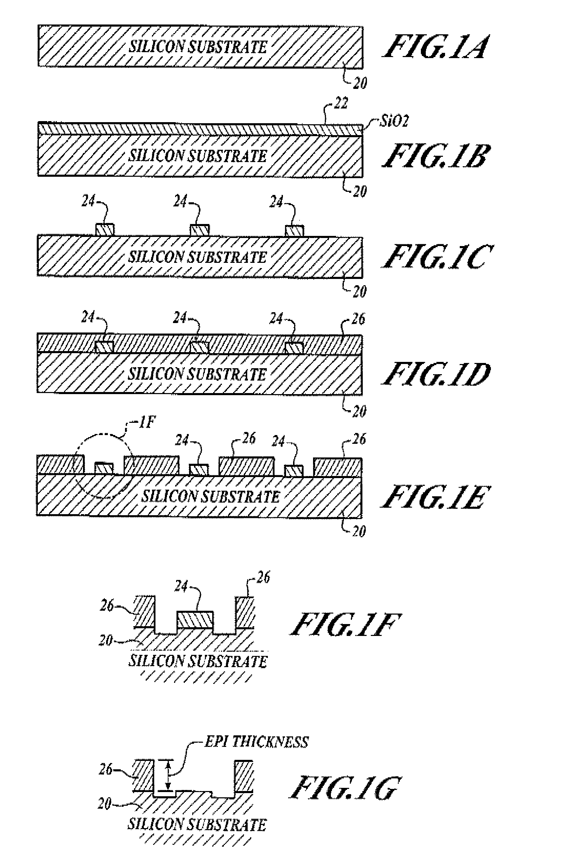

FIGURES 1A-1G illustrate partial cross-sectional views of a wafer through various stages of a process that allows for the highly accurate method for preparing an epitaxial layer for measurement.

FIGURE 1A illustrates a wafer 20 that is formed of silicon substrate. At FIGURE 1B, a layer of silicon oxide (SiO₂) 22 is applied to the silicon substrate. At FIGURE 1C, a mask, such as a photoresist, has been applied to the oxide layer 22 and the exposed oxide is etched according to the mask. The photoresist is then removed and what remains is the silicon substrate with the oxide posts 24. The oxide posts 24 may be distributed at various locations about the wafer 20.

At a FIGURE 1D, an epitaxial layer 26 is grown on top of the substrate and the oxide posts 24. The epitaxial layer 26 is grown to a pre-specified height specification. At a FIGURE lE, a pattern/mask is applied over the epitaxial layer 26 in order to mask off everything but a region around the oxide posts 24. Then, the epitaxy layer in the exposed regions is removed by silicon DRIE (Deep Reactive Ion Etch).

As shown in FIGURE IF, the exposed epitaxial layer has been removed as well as some of the silicon substrate from the wafer 26. The pattern/mask is then removed and at FIGURE 1G, the oxide posts 24 are removed by an etching process, such as Buffered Oxide Etch (BOE) or other oxide etching techniques. At this point, the thickness of the epitaxial layer 26 can be accurately measured by a profilometer or other measuring device by measuring the difference between the exposed top surface of the epitaxial layer 30 and a surface 32 that is exposed after removal of the oxide post 24. The exposed surface 32 is the original surface of the wafer 20.

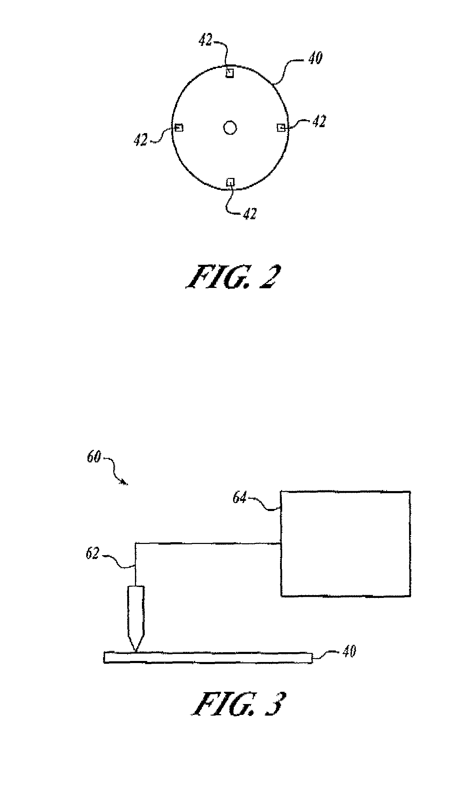

FIGURE 2 illustrates a top view of a wafer 40 that includes four epitaxial thickness layer test regions 42 that are distributed about the wafer 40. In this embodiment, each of the test areas 42 include one or more of the measurement regions (FIGURE 1G). This allows a user to analyze a plurality of locations on a silicon wafer in a nondestructive manner without taking up very much space at all.

FIGURE 3 illustrates an epitaxial thickness measuring device 60 that includes a profilometer 62 that is in data communication with a controller 64. The profilometer 62 measures the height of the surface of the epitaxial layer (surface 30, FIGURE 1G) and compares that to the height of the exposed surface of the silicon substrate that was exposed after removal of the oxide posts 24 (surface 32, FIGURE 1G). The device 60 quickly and accurately measures the epitaxial layer at each of the test locations 42 and at multiple locations within each of the test locations 42. In one embodiment, the controller 64 takes the average of the measured height values from multiple locations and determines if the epitaxial layer 26 meets predefined thickness standards.

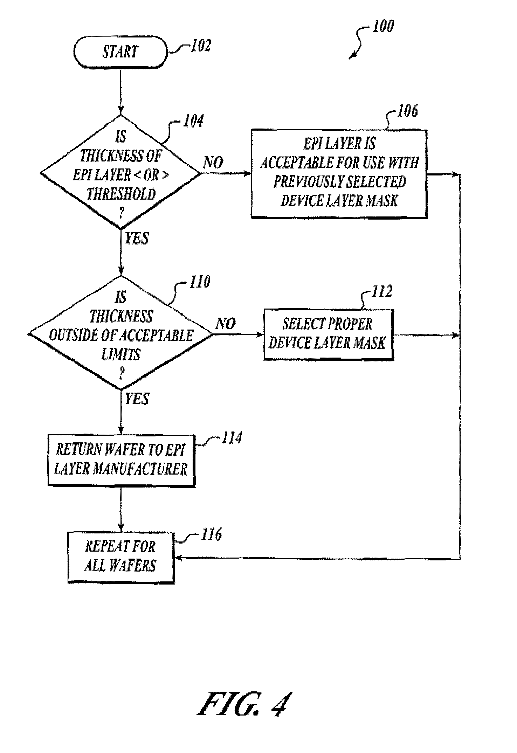

FIGURE 4 illustrates a flow diagram of a process 100 that is performed using the processes and systems described above. First, at a decision block 104, an operator determines based on the information outputted by the device 60 if the thickness of the epitaxial layer is less than or greater than a predefined threshold value. In this example, the predefined threshold value is an epitaxial thickness range associated with a particular device layer mask(s). If at the decision block 104, the thickness of the epitaxial layer is not less than or greater than the threshold value, then at a block 106, the epitaxial layer is acceptable for use with the device layer mask that is associated with the threshold value. If the thickness of the epitaxial thickness is either less than or greater than the threshold value then, at a decision block 110, the operator determines if the thickness is outside of acceptable limits. Acceptable limits would be an epitaxial layer thickness that is outside of specifications for any device layer masks that are presently used. If at the decision block 110, the thickness of the epitaxial layer is not outside the acceptable limits, then at a block 112, the operator selects a proper device layer mask that would be acceptable for use with the measured thickness of the epitaxial layer. If, however, at the decision block 110, the thickness is outside of acceptable limits, the manufacturer who grew the epitaxial layer on the wafers informed of a failure at a block 114. At this stage, the epitaxy manufacturer may re-tool in order to adjust their system in order to get the epitaxial layer growth to fall within acceptable limits. After the steps performed at blocks 106, 112, and 114, the entire process is repeated for all wafers, see block 116.

## Claims

1. A method for measuring thickness of an epitaxial layer (26) grown on a silicon wafer (20), the method comprising:
protecting a first surface (32) of the silicone wafer (20) at one or more locations;
growing an epitaxial layer (26) on the surface (32) of the silicon wafer (20) over one or more of the protected locations;
removing the epitaxial layer (26) in an area that includes at least the epitaxial layer (26) grown on one or more protected locations;
exposing the surface (32) of the silicon wafer (20) that was previously protected; and
determining the thickness of the epitaxial layer (26) by measuring a distance along an axis between the previously protected surface (32) of the silicon wafer (20) and a top surface (30) of the epitaxial layer (26) at one or more previously protected locations, the axis being approximately perpendicular to the surface (32) of the wafer (20).

2. The method of Claim 1, wherein determining includes repeating the determination of the thickness of the epitaxial layer (26) based on one or more previously protected locations.

3. The method of Claim 2, wherein determining further includes averaging the results of the thickness determinations.

4. The method of Claim 1, further comprising:
selecting a device layer mask based on the determined thickness (106,112).

5. The method of Claim 1, further comprising:
indicating the epitaxial layer (26) growth has failed (114), if the determined thickness is at least one of greater than or less than an acceptable range of thicknesses (110).

6. A system for measuring thickness of an epitaxial layer (26) grown on a silicon wafer (20), the system comprising:
a means for protecting a first surface (32) of the silicone wafer (20) at one or more locations;
a means for growing an epitaxial layer (26) on the surface (32) of the silicon wafer (20) over one or more of the protected locations;
a means for removing the epitaxial layer (26) in an area that includes at least the epitaxial layer (26) grown on one or more protected locations;
a means for exposing the surface (32) of the silicon wafer (20) that was previously protected; and
a measuring device (60) configured to determine the thickness of the epitaxial layer (26) by measuring a distance along an axis between the previously protected surface (32) of the silicon wafer (20) and a top surface (30) of the epitaxial layer (26) at one or more previously protected locations, the axis being approximately perpendicular to the surface (32) of the wafer (20).

7. The system of Claim 6, wherein the measuring device (60) repeats the determination of the thickness of the epitaxial layer (26) based on one or more previously protected locations.

8. The system of Claim 7, further comprising a processor (64) configured to average the thickness determinations.

9. The system of Claim 6, further comprising:
a means for selecting a device layer mask based on the determined thickness (106,112).

10. The system of Claim 6, further comprising:
a means for indicating the epitaxial layer (26) growth has failed (114), if the determined thickness is at least one of greater than or less than an acceptable range of thicknesses (110).
